# EUROPEAN PATENT APPLICATION

(11) **EP 4 568 448 A1**
(43) Date of publication of application: **11.06.2025**
(21) Application number: 24209153.6
(22) Date of filing: 28.10.2024
(51) Int. Cl.: H10D 62/10, H10D 30/01, H10D 30/00, H10D 30/67, H10D 62/13

(54) **INTEGRATED CIRCUIT STRUCTURES WITH BACKSIDE CONTACTS AND ASYMMETRIC SOURCE AND DRAIN REGIONS**

(30) Priority: 06.12.2023 US 202318530744
(71) Applicant: INTEL Corporation, Santa Clara, CA 95054 (US)
(72) Inventor: Chu, Tao, Portland, OR 97229 (US); Xu, Guowei, Portland, OR 97229 (US); Huang, Chiao-Ti, Portland, OR 97229 (US); Chao, Robin, Portland, OR 97229 (US); Zhang, Feng, Hillsboro, OR 97123 (US); Hung, Ting-Hsiang, Beaverton, OR 97007 (US); Lin, Chia-Ching, Portland, OR 97229 (US); Zhang, Yang, Rio Rancho, NM 87124 (US); Zhang, Kan, Hillsboro, OR 97123 (US); Lindert, Nick, Portland, OR 97229 (US); Paik, Marvin Young, Portland, OR 97229 (US); Packan, Paul, Hillsboro, OR 97124 (US); Lin, Chung-Hsun, Portland, OR 97229 (US); Murthy, Anand S., Portland, OR 97229 (US); Jang, Minwoo, Portland, OR 97229 (US)
(74) Representative: Goddar, Heinz J.

(57) **Abstract**

Fabrication methods for integrated circuit (IC) structures and devices including asymmetric source and drain regions are described herein. In one example, an integrated circuit structure includes a transistor including a first region and a second region, where one of the first region and the second region is a source region of the transistor, and another of the first region and the second region is a drain region of the transistor, and where the first and second regions have different widths. In one example, the first region has a first width and the second region has a second width that is smaller than the first width.

## Description

### Background

For the past several decades, the scaling of features in integrated circuit (IC) structures has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize every portion of an IC structure becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon-based field-effect transistor (FET), according to some embodiments of the present disclosure.
FIGS. 2A-2C illustrate examples of IC structures including asymmetric source and drain regions.
FIG. 3 is a flow diagram of an example method of fabricating an IC structure including asymmetric source and drain regions, in accordance with some embodiments.
FIGS. 4A-4P provide cross-sectional side views at various stages in the fabrication of an example IC structure according to the method of FIG. 3, in accordance with some embodiments.
FIG. 5 is a top view of a wafer and dies that may include any of the IC structures disclosed herein, in accordance with any of the embodiments disclosed herein.
FIG. 6 is a side, cross-sectional view of an IC device that may include any of the IC structures disclosed herein, in accordance with any of the embodiments disclosed herein.
FIG. 7 is a side, cross-sectional view of an IC package that may include any of the IC structures disclosed herein, in accordance with various embodiments.
FIG. 8 is a side, cross-sectional view of an IC device assembly that may include any of the IC structures disclosed herein, in accordance with any of the embodiments disclosed herein.
FIG. 9 is a block diagram of an example electrical device that may include any of the IC structures disclosed herein, in accordance with any of the embodiments disclosed herein.

### Detailed Description

Disclosed herein is a fabrication method and associated IC structures, and devices including asymmetric source and drain regions (referred to herein as "asymmetric S/D regions"). The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

For purposes of illustrating fabrication of nanoribbon-based transistors with asymmetric S/D regions, described herein, it might be useful to first understand phenomena that may come into play during IC fabrication. The following foundational information may be viewed as a basis from which the present disclosure may be properly explained. Such information is offered for purposes of explanation only and, accordingly, should not be construed in any way to limit the broad scope of the present disclosure and its potential applications.

Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

Nanoribbon-based transistors may be particularly advantageous for continued scaling of metal-oxide-semiconductor (MOS) technology nodes due to the potential to form gates on all four sides of a channel material (hence, such transistors are sometimes referred to as "gate all around" transistors). As used herein, the term "nanoribbon" refers to an elongated structure of a semiconductor material having a longitudinal axis parallel to a support structure (e.g., a substrate, a die, a chip, or a wafer; also referred to herein as, simply, "support") over which such a structure is built. Typically, a length of a such a structure (i.e., a dimension measured along the longitudinal axis, shown in the present drawings to be along the y-axis of an example x-y-z coordinate system) is greater than each of a width (i.e., a dimension measured along the x-axis of the example coordinate system shown in the present drawings) and a thickness (i.e., a dimension measured along the z-axis of the example coordinate system shown in the present drawings). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections. In the present disclosure, the term "nanoribbon" is used to refer to all such nanowires, nanoribbons, and nanosheets, as well as elongated semiconductor structures with a longitudinal axis parallel to the support structures and with having transverse cross-sections of any geometry (e.g., transverse cross-sections in the shape of an oval or a polygon with rounded corners). A transistor may then be described as a "nanoribbon-based transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with source and drain (S/D) regions of a transistor provided on either side of the channel material.

As mentioned briefly above, the drive for increased capacity has led to shrinking transistor sizes. Smaller transistors can be achieved by shrinking the dimensions of one or more elements of the transistors. However, shrinking transistor sizes has led to challenges related to short channel effects. As the name suggests, short channel effects are typically greater as the length of the channel becomes shorter. Short channel effects can result in issues such as increased leakage current, drain-induced barrier lowering, velocity saturation, unintentional reduction in threshold voltage, and unintentional subthreshold conduction through the transistor, all of which can negatively impact performance and/or result in failure of the transistors. One approach for achieving smaller transistor sizes while keeping short channel effects within acceptable limits is to focus on reducing the dimensions of other elements of the transistor, such as the S/D regions. However, shrinking the size of the S/D regions can also result in yield and performance issues stemming from, e.g., poor electrical conductivity and process limitations.

Embodiments of the present disclosure are based on recognition that forming nanoribbon transistors with asymmetric source and drain regions can enable achieving smaller transistor sizes without excessive short channel effects. Conventionally, the source and drain regions of nanoribbon transistors are symmetric (e.g., have about the same widths). Shrinking the width of only one of the S/D regions can enable fabrication of a nanoribbon transistor with a larger channel length without increasing the overall width of the transistor and without the yield and performance issues associated with shrinking the size of both S/D regions. Shrinking the width of one of the S/D regions (e.g., the source region) can also, or alternatively, enable a larger width for the other S/D region and contact structure (e.g., the drain region). In some examples, shrinking the width of one of the S/D regions (e.g., the source region) and/or the corresponding S/D contact structure may not negatively impact the yield and performance as much as shrinking the other S/D region (e.g., the drain region) and/or corresponding S/D contact structure. Additionally, in one example, the narrower S/D region can be coupled with a contact structure from a side of the IC structure that is opposite the side from which the S/D regions were formed (e.g., a back side). In one such example, providing a back-side contact structure for the narrower S/D region can enable more flexibility in ensuring the S/D contact makes sufficient contact with the narrower S/D region for good current conduction. Thus, in one example, a narrower source region may be coupled with a back-side source contact structure, and a wider drain region may be coupled with a front side contact structure. In accordance with examples described herein, short channel effects may be improved due to the increased channel length made possible by the asymmetric S/D regions.

IC structures as described herein, in particular IC structures including asymmetric source and drain regions, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

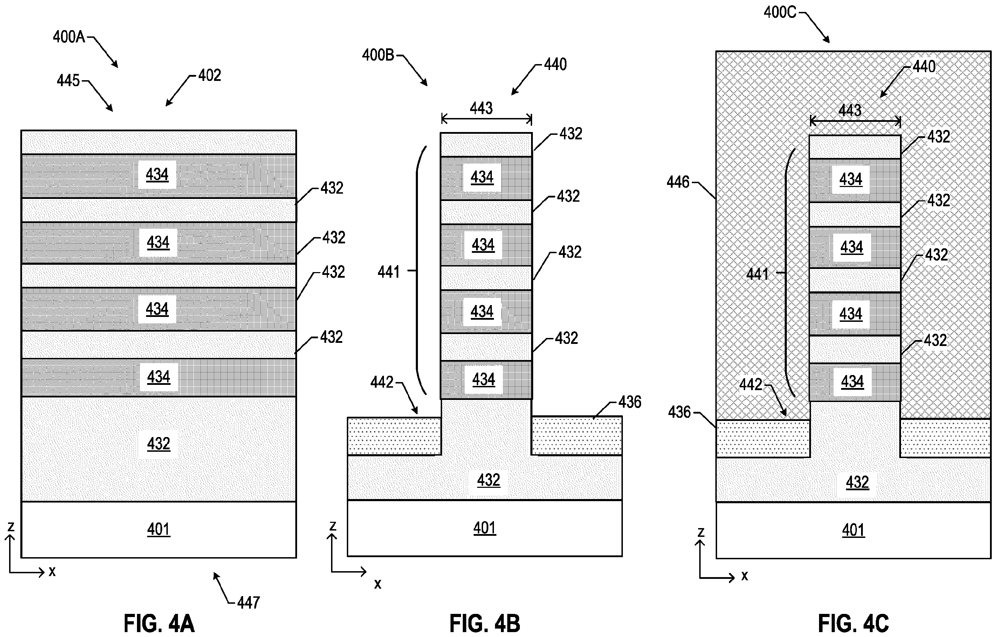

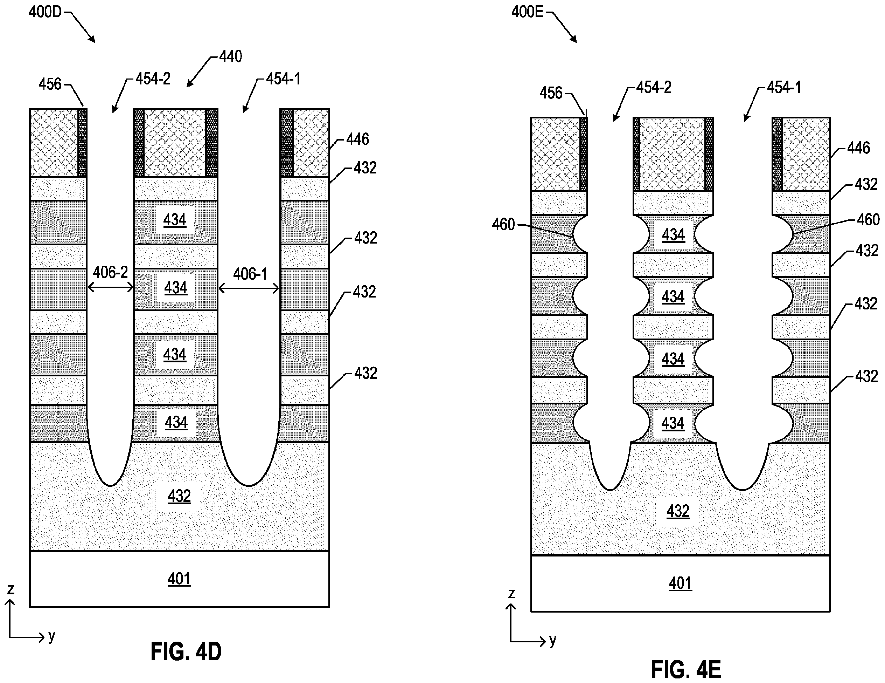

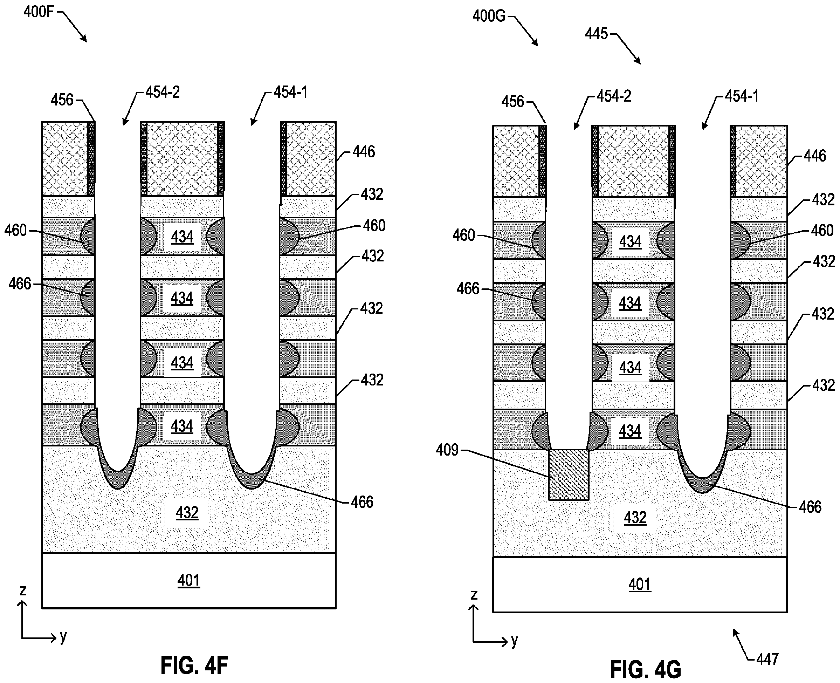

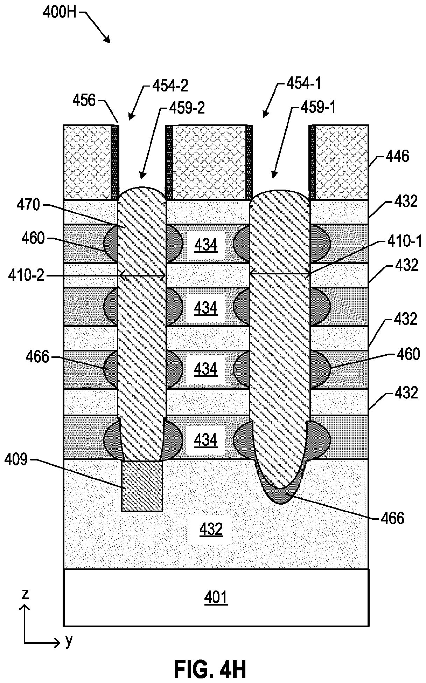

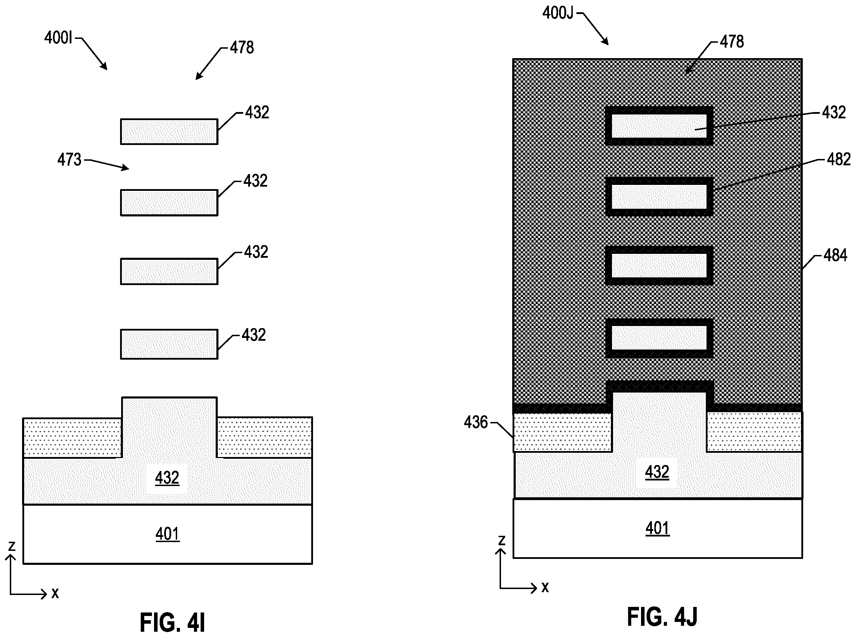

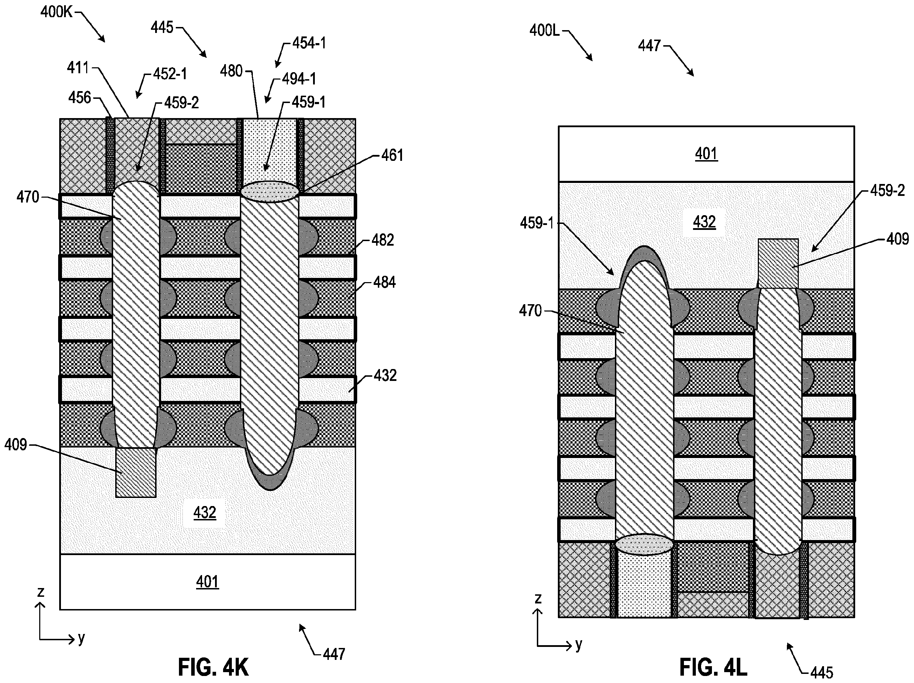

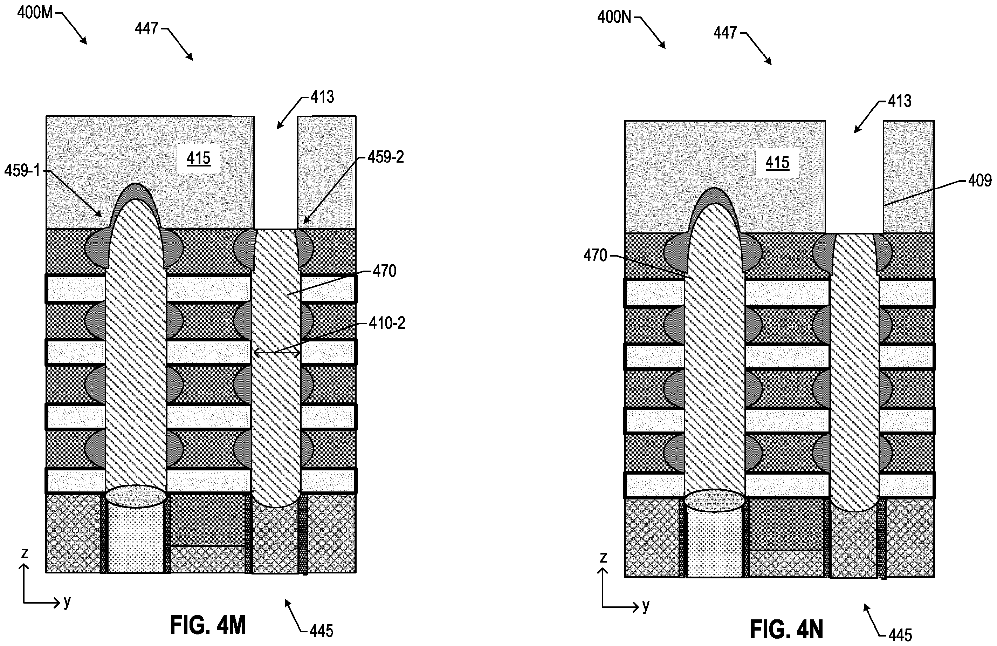

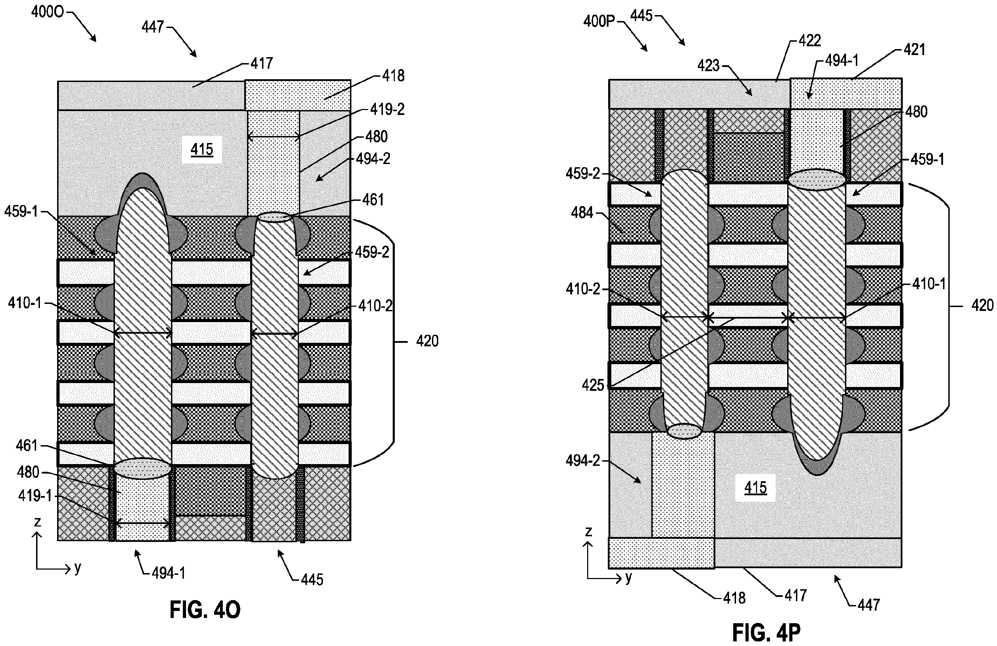

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 4A-4P, such a collection may be referred to herein without the letters, e.g., as "FIG. 4."

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of the presence of IC structures including asymmetric source and drain regions as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

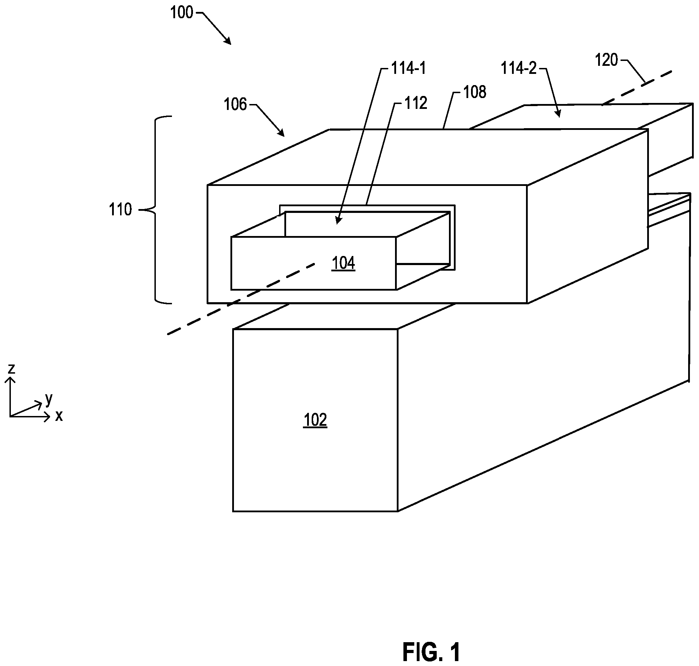

FIG. 1 provides a perspective view of an example IC structure 100 with a nanoribbon transistor 110, according to some embodiments of the present disclosure. As shown in FIG. 1, the IC structure 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2 (referred to herein as simply "S/D regions 114), on either side of the gate stack 106. One of the S/D regions 114 is a source region and the other one is a drain region. However, because, as is common in the field of FETs, designations of source and drain are often interchangeable, they are simply referred to herein as a first S/D region 114-1 and a second S/D region 114-2.

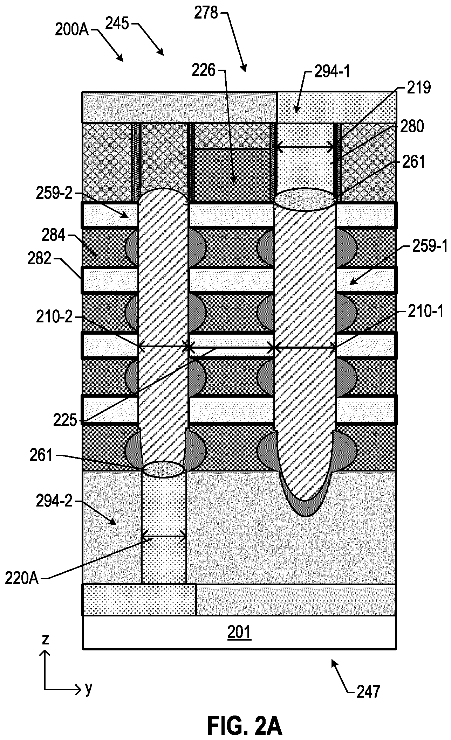

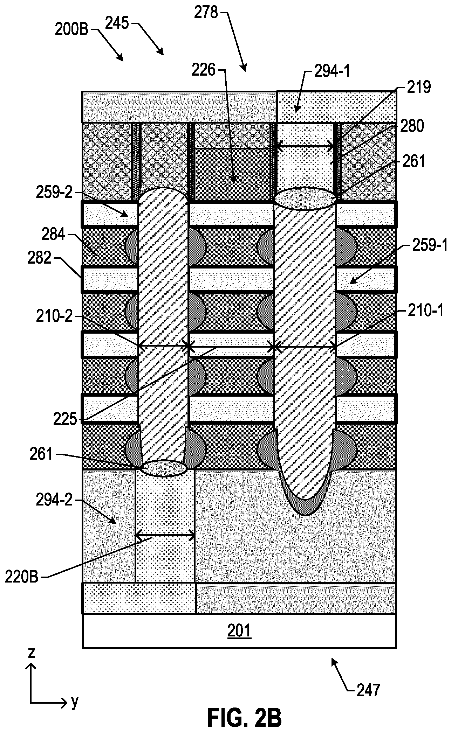

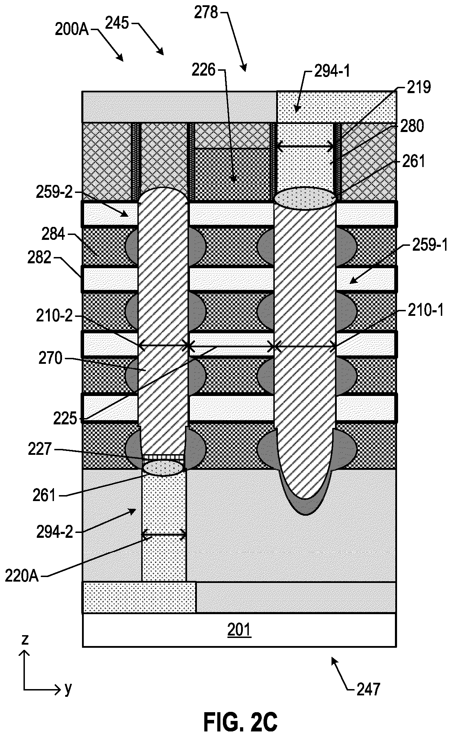

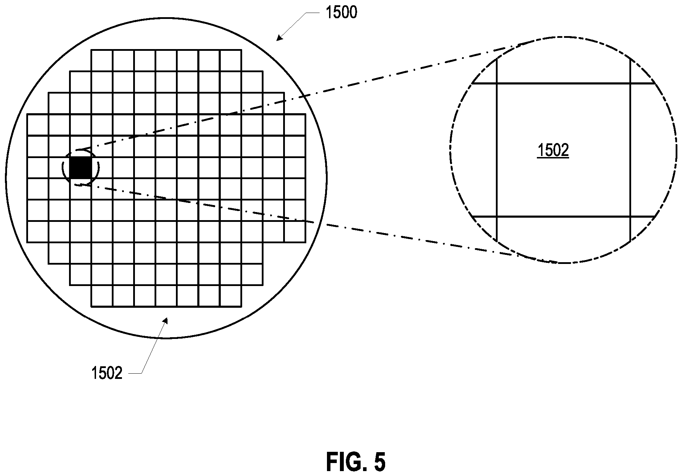

Implementations of the present disclosure may be formed or carried out on any suitable support 102, such as a substrate, a die, a wafer, or a chip. The support 102 may, e.g., be the wafer 1500 of FIG. 5, discussed below, and may be, or be included in, a die, e.g., the singulated die 1502 of FIG. 5, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC structure including a self-insulated via as described herein may be built falls within the spirit and scope of the present disclosure. Although only one nanoribbon 104 is shown in FIG. 1, the IC structure 100 may include a stack of such nanoribbons where a plurality of nanoribbons 104 are stacked above one another. For example, FIG. 2, and FIGS. 20-21 show IC structures that may be examples of the IC structure 100. In some embodiments, a portion of the support 102 right below the lowest nanoribbon 104 of the stack may be shaped as a subfin extending away from a base, as is known in the field of nanoribbon transistors.

The nanoribbon 104 may take the form of a nanowire or nanoribbon, for example. In some embodiments, an area of a transversal cross-section of the nanoribbon 104 (i.e., an area in the x-z plane of an x-y-z coordinate system shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width of the nanoribbon 104 (i.e., a dimension measured in a plane parallel to the support 102 and in a direction perpendicular to the longitudinal axis 120 of the nanoribbon 104, e.g., along the x-axis of the coordinate system) may be at least about 3 times larger than a height or thickness of the nanoribbon 104 (i.e., a dimension measured in a plane perpendicular to the support 102, e.g., along the z-axis of the coordinate system), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, Nor P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., front-end components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include one or more gate electrode materials, where the choice of the gate electrode materials may depend on whether the transistor 110 is a PMOS transistor or an NMOS transistor. For a PMOS transistor, gate electrode materials that may be used in different portions of the gate electrode material 108 may include, but are not limited to, ruthenium, palladium, platinum, cobalt, nickel, and conductive metal oxides (e.g., ruthenium oxide). For an NMOS transistor, gate electrode materials that may be used in different portions of the gate electrode material 108 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode material 108 may include a stack of a plurality of gate electrode materials, where zero or more materials of the stack are workfunction (WF) materials and at least one material of the stack is a fill metal layer. Further materials/layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabrication of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and S/D contacts of the transistor 110 and could be made of a low-k dielectric material, some examples of which have been provided above.

Turning to the S/D regions 114 of the transistor 110, in some embodiments, the S/D regions may be highly doped, e.g., with dopant concentrations of about 10²¹ cm⁻³, in order to advantageously form Ohmic contacts with the respective S/D contacts (not shown in FIG. 1), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. Even when doped to realize threshold voltage tuning as described herein, the channel portions of transistors typically include semiconductor materials with doping concentrations significantly smaller than those of the S/D regions 114.

The S/D regions 114 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114. An epitaxial deposition process may then be carried out to fill the recesses with material that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. And in further embodiments, one or more layers of metal and/or metal alloys may be used to form the S/D regions 114. In some embodiments, a distance between the first and second S/D regions 114 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114 of the transistor 110, additional layers such as a spacer layer around the gate electrode of the transistor 110, etc.). For example, although not specifically illustrated in FIG. 1, a dielectric spacer may be provided between a first S/D contact (which may also be referred to as a "first S/D electrode") coupled to a first S/D region 114-1 of the transistor 110 and the gate stack 106 as well as between a second S/D contact (which may also be referred to as a "second S/D electrode") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

FIGS. 2A-2C illustrate examples of IC structures including asymmetric S/D regions. FIG. 2A illustrates an example of an IC structure 200A where a first S/D region has a larger width than a second S/D region. FIG. 2B illustrates an example of an IC structure 200B similar to the IC structure 200A, where an opening for a contact structure has been widened from a second side of the IC structure 200B to provide for a wider contact structure coupled with the narrower S/D region than in FIG. 2A. FIG. 2C illustrates an example of an IC structure 200C similar to the IC structures 200A and 200B of FIGS. 2A-2B, with an S/D region including a first semiconductor material, an S/D contact structure at a second side of the IC structure 200C, and a second semiconductor material between the first semiconductor material of the S/D region and the S/D contact structure.

Turning first to FIG. 2A, the IC structure 200A includes a support structure 201 and a stack 278 of nanoribbons (e.g., two or more nanoribbons) stacked above one another over the support structure 201. The support structure 201 can be, for example, a substrate, a die, a chip, a wafer, or other support structure, and may be referred to herein as a "support." In the illustrated example, the nanoribbons of the stack 278 include a semiconductor material in which channel portions or channel regions 226 of a transistor are formed.

The IC structure 200A of FIG. 2A includes a gate insulator material 282 that may wrap around the channel regions 226 of the nanoribbons of the stack 278, as well as a gate electrode material 284. In the illustrated example, the gate electrode material 284 is a continuous gate electrode material that encloses the channel regions 226 of a transistor. The gate insulator material 282 can include a high-k dielectric or other suitable insulator material. The gate electrode material 284 can include a conductive material in accordance with examples described above. In some embodiments, the gate insulator material 282 may be absent in the IC structure 200A.

The channel regions 226 are between S/D regions 259-1 and 259-2, where one of the regions 259-1, 259-2 is a source region and the other of the regions 259-1, 259-2 is a drain region. In one example, the S/D regions 259-1, 259-2 are regions including a doped semiconductor material, which act as source and drain regions for a transistor. The IC structure 200A includes a first contact structure 294-1 coupled with the first S/D region 259-1 from a first side 245 of the IC structure 200A (referred to herein as a front side, which may also be a front side of a wafer in or on which the IC structure 200A is formed). The IC structure 200A further includes a second contact structure 294-2 coupled with the second S/D region 259-2 from a second side 247 of the IC structure 200A (referred to herein as a back side of the IC structure 200A, which may also be a back side of a wafer in or on which the IC structure 200A is formed). The IC structure also includes an interface material 261 between the S/D regions 259-1, 259-2 and the conductive material 280 of the respective S/D contact structures 294-1, 294-2.

As can be seen in FIG. 2A, the IC structure 200A has asymmetric S/D regions in the sense that the first S/D region 259-1 has a first width 210-1 and the second S/D region 259-2 has a second width 210-2 that is different than the first width 210-1, where the widths 210-1, 210-2 are dimensions of the corresponding S/D regions in a plane substantially parallel with the support 201 (e.g., in the x-y plane, where the x-axis is going into and coming out of the page of FIG. 2A). In the example illustrated in FIG. 2A, the second width 210-2 is smaller than the first width 210-1. The S/D regions 259-1, 259-2 may not have perfectly straight sidewalls, and therefore it is possible that the width of an S/D region 259-1 or 259-2 may be different at different points along the height of the S/D region 259-1 or 259-2, where the height is a dimension of the S/D region in a plane substantially parallel to the support 201 (e.g., along the z-axis as shown in FIG. 2A). Therefore, the widths 210-1, 210-2 are widths of the S/D regions 259-1 and 259-2 in the same plane. In one example, the widths 210-1, 210-2 may be the widths of the S/D regions 259-1, 259-2 in a plane near the mid-point of the height of the S/D region or above (e.g., not in tapered portions of the S/D regions 259-1, 259-2). In one example, the widths 210-1, 210-2 may be the widths of the S/D regions 259-1, 259-2 in a plane corresponding to a widest portion of the S/D region 259-1.

In one example, the extent to which the width 210-2 of the S/D region 259-2 can be reduced relative to the width 210-1 may depend on factors such as process limitations, the contact area between the S/D region 259-2 and the corresponding contact structure 294-2 to enable sufficient conduction, and desired electrical characteristics such as resistance and current conductance. In one such example, the width 210-2 is 5-60% smaller than the width 210-1. In other examples, the width 210-2 is 20-40% smaller, or 25-35% smaller than the width 210-1. In one example, the difference in width between the S/D regions 259-1, 259-2 is in a range of about 2-5 nanometers. For example, if the width 210-1 of the S/D region 259-1 is about 11 or 12 nanometers, the width of the S/D region 259-2 may be about 8 nanometers. However, other widths of S/D regions are possible (e.g., the S/D regions 259-1, 259-2 may have widths that are less than 8 nanometers or greater than 12 nanometers).

In accordance with some examples, the widths of the S/D contact structures may also be different. For example, the IC structure 200A depicted in FIG. 2A includes a contact structure 294-1 having a width 219 that is greater than the width 220A of the contact structure 294-2. In the example illustrated in FIG. 2A, the widths of both the S/D region 259-2 and the S/D contact structure 294-2 are smaller than the widths of the S/D region 259-1 and the S/D contract structure 294-1, respectively.

Thus, the example IC structure 200A illustrated in FIG. 2A includes asymmetric S/D regions where the first width 210-1 of the first S/D region 259-1 is different than the second width 210-2 of the second S/D region 259-2. As can be seen in FIG. 2A, the S/D region 259-2 with the back-side contact structure 294-2 has a narrower width than the S/D region 259-1 with the front-side contact structure 294-1. However, in other examples, the narrower S/D region may be coupled with a front-side contact. The asymmetric S/D regions can enable a longer channel length 225 (e.g., due to the smaller width 210-2 of the S/D region 259-2), which may result in reduced short channel effects.

FIG. 2B illustrates another example IC structure 200B with asymmetric S/D regions similar to the IC structure 200A, but with a wider back-side S/D contact structure 294-2 coupled with the narrower S/D region 259-2. As can be seen in FIG. 2B, the S/D contact structure 294-2 has a width 220B that is wider than the width 210-2 of the S/D region to which the contact structure 294-2 is coupled. In one such example, when forming the contact structure 294-2, the opening for the contact structure is widened from the second side 247 to enable a contact structure with a larger width 220B to be provided. The width 220B of the contact structure 294-2 may be smaller than, about the same as, or larger than the width 219 of the contact structure 294-1. In one such example, the width 220B is greater than the width 210-2 of the S/D region 259-2 and smaller than the width 219 of the contact structure 259-1. According to some examples, a wider contact structure 294-2 may enable a better contact area with the S/D region 259-2 and better conduction through the contact structure 294-2.

FIG. 2C illustrates an example of an IC structure 200C that is similar to the IC structures 200A and 200B of FIGS. 2A-2B, with an additional semiconductor material between the S/D region 259-2 and the S/D contact 294-2. As can be seen in FIG. 2C, the S/D region 259-2 including a first semiconductor material 270, and the IC structure 200C further includes a second semiconductor material 227 between the first semiconductor material 270 of the S/D region 259-2 and the S/D contact structure 294-2. In an example in which there is an interface material between the S/D region 259-2 and the S/D contact structure 294-2, the second semiconductor material 227 may be between the interface material 261 and the first semiconductor material 270 of the S/D region 259-2. In one such example, the second semiconductor material 227 is in direct contact with the first semiconductor material 270 of the S/D region 259-2 and in direct contact with the interface material 261 (or in direct contact with the conductive material 280 of the contact structure 294-2 in an example without the interface material 261). In one example, the second semiconductor material 261 has at least one different material property than the first semiconductor material of the S/D region 259-2, including one or more of a different material composition and a different crystal direction. In one example, the second semiconductor material 227 is absent from the S/D region 259-1 and the contact structure 294-1. According to some examples, including the second semiconductor material 227 between the S/D region 259-2 and the contact structure 294-2 can enable a better connection (e.g., by filling a gap in the first semiconductor material 270 in the bottom of the S/D region 259-2 that may have been caused by defects and/or as a side effect of the processes to form the narrower S/D region with a back-side contact). Note that although the IC structure 200C is shown as having a relatively narrow contact structure 494-2 similar to the IC structure 200A, an IC structure including a second semiconductor material 227 may also include a wider contact structure (such as shown in FIG. 2B).

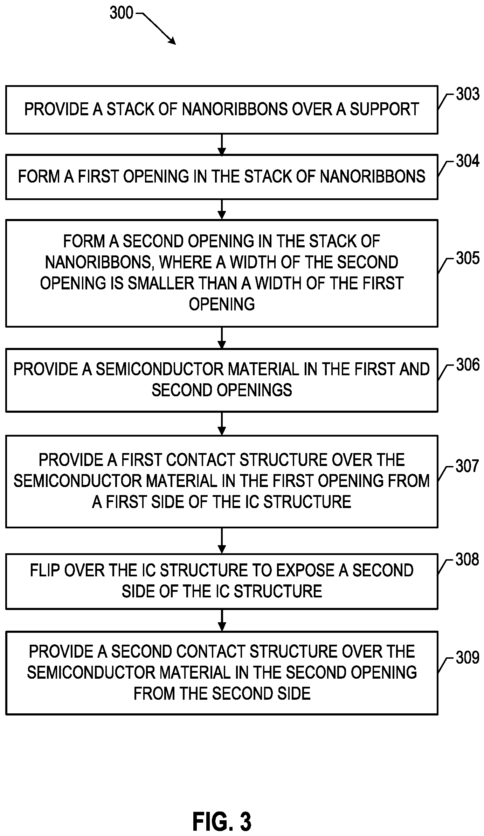

FIG. 3 is a flow diagram of an example method for fabricating an IC structure including asymmetric source and drain regions, in accordance with some embodiments.

Although the operations of the method of FIG. 3 are illustrated once each and in a particular order, the operations may be performed in any suitable order and repeated as desired. For example, one or more operations may be performed in parallel to fabricate multiple IC structures with asymmetric source and drain regions substantially simultaneously. In another example, the operations may be performed in a different order to reflect the structure of an IC device including asymmetric source and drain regions.

In addition, the example fabricating method of FIG. 3 may include other operations not specifically shown in FIG. 3, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method of FIG. 3 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface. FIGS. 4A-4P provide cross-sectional side views at various stages in the fabrication of an example IC structure according to the method of FIG. 3, in accordance with some embodiments.

Turning to FIG. 3, the method 300 begins with a process 303 of providing a stack of nanoribbons over a support. Providing a stack of nanoribbons over a support may include, for example, providing a stack of alternate layers of a semiconductor material and another material (e.g., another semiconductor material) and forming a fin from the stack. A dummy gate can then be provided around gate regions of the fin. IC structures 400A-400C of FIGS. 4A-4C illustrate an example result of the process 303.

For example, the IC structure 400A of FIG. 4A illustrates an example result of providing a stack of alternate layers of a semiconductor material and another material from a first side 445 of the IC structure 400A (e.g., a front side of the IC structure 400A, which may also be a front side of a wafer in or on which the IC structure 400A is formed). The IC structure 400A includes a support 401 and alternating layers of a semiconductor 432 and layers of another material 434. While FIG. 4A illustrates five layers of the semiconductor material and four layers of the material 434 in a stack 402, in other embodiments, any other number of layers may be used as long as they are alternating and include at least three layers of the semiconductor material 432 and at least two layers of the material 434. The upper layers of the semiconductor material 432 will later be formed into nanoribbons stacked above one another, as shown in FIGS. 4C-4P, discussed below. Thus, although a particular number of nanoribbons formed of the upper layers of the semiconductor material 432 is depicted in FIG. 4B (namely, four nanoribbons) and subsequent drawings, embodiments of the present disclosure include IC structures having more or fewer stacked nanoribbons than depicted.

As shown in FIG. 4A, in some embodiments, the alternation of layers of the semiconductor material 432 and the material 434 may begin after a bottom layer of the semiconductor material 432 is provided over the support 401. In one such example, the bottom layer of the semiconductor material 432 may later form a subfin under the stack of nanoribbons. Although the thickness of the bottom layer of the semiconductor material 432 is depicted as being greater than the subsequent layers of the semiconductor material 432 that are formed into nanoribbons via further processing, in other examples, the bottom layer of the semiconductor material 432 may have a substantially same thickness as another layer of the semiconductor material 432.

The semiconductor material 432 may be any of the semiconductor/channel materials described above with reference to the nanoribbon 104 of FIG. 1. The material 434 may be any suitable material that is etch-selective with respect to the semiconductor material 432 so that, in a later process, the material 434 may be etched away to form nanoribbons of the semiconductor material 432. As known in the art, two materials are said to be "etch-selective" (or said to have "sufficient etch selectivity") with respect to one another when etchants used to etch one material do not substantially etch the other, enabling selective etching of one material but not the other. For example, in some embodiments, the semiconductor material 432 may be silicon while the material 434 may be a second semiconductor material such as silicon germanium. In another example, the semiconductor material 432 may be silicon germanium, while the material 434 may be silicon. In other examples, the material 434 may be made of a non-semiconductor material, e.g., of an insulator material, as long as this material is sufficiently etch-selective with respect to the semiconductor material 432.

Thus, the material 434 may be any suitable sacrificial material that is etch-selective with respect to the semiconductor material 432. Selecting the material 434 to be a semiconductor material may be particularly advantageous because it may improve quality of the semiconductor material 432 if the semiconductor material 432 is epitaxially grown on the material 434. In some embodiments, the process may include epitaxially growing layers of the semiconductor material 432 and the material 434 (e.g., another semiconductor material) in an alternating manner. In other embodiments, alternate layers of the semiconductor material 432 and the material 434 may be provided in the process using other techniques, such as layer transfer or thin-film deposition. Although FIGS. 4A-4C illustrate the same semiconductor material 432 in various layers of the IC structures 400A-400C, in general, material compositions of a semiconductor material from which nanoribbons will later be formed in different layers of the IC structure 400A-400C may be different. For example, the semiconductor material 432 of one layer of the IC structure 400A may be silicon while the semiconductor material 432 of another layer of the IC structure 400A may be a III-N semiconductor material such as GaN.

FIG. 4B illustrates an example of an IC structure 400B resulting from the process of forming a fin from the stack of alternate layers of semiconductor material and another material. The IC structure 400B illustrates that the stack 402 of alternating layers of the semiconductor material 432 and the material 434 has been patterned into a fin 440. The fin 440 may include an active portion 441 and subfin portions 442. The active portions 441 may be a portion of the fin 440 from which nanoribbons will be formed, while the subfin portion 442 is a portion of the fin 440 that has sidewalls at least partially enclosed with an insulator material 436, e.g., as shown in FIG. 4B. The insulator material 436 may include any of insulator material typically used as a "shallow trench insulator" (STI) in fin-based or nanoribbon-based transistors, e.g., any suitable low-k dielectric material or other suitable insulator material.

Thus, the fin 440 may be shaped as a structure that extends away from the support 401 and may include a subfin 442 at the bottom, the subfin being a portion of the respective fin that is at least partially enclosed by an insulator material 436. In some embodiments, the subfin 442 may include the bottom layer of the semiconductor material 432, as well as an upper portion of the support 401, as is shown in FIG. 4B. However, in other embodiments, the subfin 442 may include only the semiconductor material 432 and not any portions of the support 401 (not shown in the present drawings). In some embodiments, semiconductor material 432 of the subfin 442 and/or the support 401 may be removed and/or replaced with one or more other materials in subsequent processes.

In the example illustrated in FIG. 4B, the fin 440 may have a width 443 (i.e., a dimension of the fin 440 measured along the x-axis of the example coordinate system shown in FIG. 4B). The width 443 may be that of the width of the nanoribbons subsequently formed (e.g., the nanoribbon 104 of FIG. 1 described above). The fin 440 may further have a length (i.e., a dimension of the fins 440 measured along the y-axis of the example coordinate system shown in FIG. 4B, where the y-axis is going into and coming out of the page) suitable to account for the length of the future nanoribbons (e.g., as described above with reference to the length of the nanoribbon 104 of FIG. 1).

In various embodiments, any suitable patterning techniques may be used to form the fin 440, such as, but not limited to, photolithographic or electron-beam (e-beam) patterning, possibly in conjunction with a suitable etching technique, e.g., a dry etch, such as e.g., RF reactive ion etch (RIE) or inductively coupled plasma (ICP) RIE. In some embodiments, the etch performed to form the fins 440 may include an anisotropic etch, using etchants in a form of e.g., chemically active ionized gas (i.e., plasma) using e.g., bromine (Br) and chloride (CI) based chemistries. In some embodiments, during the etch to form the fins 440, the IC structure may be heated to elevated temperatures, e.g., to temperatures between about room temperature and 200 degrees Celsius, including all values and ranges therein, to promote that byproducts of the etch are made sufficiently volatile to be removed from the surface.

After forming the fin 440, a dummy gate material may then be provided around gate regions of the fin. FIG. 4C illustrates an example IC structure 400C resulting from the process of providing a dummy gate. The IC structure 400C illustrates the fin 440 over the support 401 and a material 446, which may be referred to as the dummy gate or replacement gate. In one example, the material 446 may be any suitable material such as polysilicon.

Referring again to FIG. 3, the method 300 continues with the process 304 of forming a first opening in the stack of nanoribbons, and the process 305 of forming a second opening in the stack of nanoribbons, where a width of the second opening is smaller than a width of the first opening. FIG. 4D illustrates an IC structure 400D resulting from the processes 304 and 305 from the perspective of the y-z plane in a cross-section along the fin 440. FIG. 4D illustrates a first opening 454-1 and a second opening 454-2 (together referred to as "openings 454") in the fin 440. Any suitable etching technique may be used to form the openings 454, such as the techniques described above with respect to the process of forming the fins. In some embodiments, portions of the openings 454 surrounded by the dummy gate 446 may be lined with a liner 456, which may include a plurality of different liners even though it is shown in FIG. 4D as a single liner 456. The liner 456 may include one or more of spacer materials, diffusion barrier materials, adhesion materials, etc., as known in the art for forming contacts to various components of IC structures.

In the example illustrated in FIG. 4D, the first opening 454-1 has a first width 406-1 and the second opening 454-2 has a second width 406-2, where the second width 406-2 is smaller than the first width 406-1. In one example, each of the openings 454 have a width in the range of about 7 nanometers to 15 nanometers. In other examples, other S/D opening widths are possible (e.g., smaller than 7 nanometers or greater than 15 nanometers). In some examples, the second width 406-2 is 5-60% smaller than the first width 406-1, 20-40% smaller than the first width 406-1, or 25-35% smaller than the first width 406-1. In one example, an S/D region that will be later coupled with a back-side contact will be formed in the opening 452-2 having the smaller width 406-2, and an S/D region that will be later coupled with a front-side contact will be formed in the opening 454-1 having the larger width. In one such example, the opening 454-2 with the smaller width 406-2 will be formed into a source region, and the opening 454-1 with the larger width 406-1 will be formed into a drain region. In other examples, the opening 454-2 with the smaller width 406-2 may be formed into a drain region, and/or may have a back-side contact.

After forming the openings 454, the method 300 may involve additional processes before providing the S/D material in the openings 454. For example, the method 300 may involve recessing a sacrificial material at sidewalls of the openings and providing a spacer material in the recessed areas. FIG. 4E illustrates an example IC structure 400E resulting from the process of recessing the material 434 in the openings 454. As can be seen in FIG. 4E, as a result of recessing the material 434, so-called "dimples" 460 may be formed in the sidewalls of the S/D openings 454 in the fin 440, where the dimples 460 are areas in which the material 434 was recessed away from the original sidewalls of the openings 454 (i.e., recessed laterally). Any suitable etching technique may be used in the process to recess the material 434 in the S/D openings 454, such as any suitable wet etching technique using etchants that can etch the material 434 without substantially etching other material of the IC structure 400E. The dimples 460 may have any suitable geometry and dimensions so that, when filled with an insulator material in a later process, the dimples 460 may provide electrical insulation between the material of the S/D regions that will be within the S/D openings 454 formed in the fin 440 and the gate electrode material that will be present between the nanoribbons of the semiconductor material 432 formed from the fins 440. For example, a depth of the dimples 460, which is a dimension that is measured along the y-axis of the example coordinate system shown, may be between about 1 and 20 nanometers, e.g., between about 2 and 10 nanometers, or between about 3 and 7 nanometers.

FIG. 4F illustrates an example IC structure 400F resulting from the process of providing a spacer material in the openings 454. As can be seen in FIG. 4F, the dimples 460 may be filled with a spacer material 466. Furthermore, the spacer material 466 may also line bottoms of the openings 454. In one such example, the spacer material 466 lines the subfin portion of the fin 440. The spacer material 466 may include any suitable insulator material and be provided using any suitable deposition technique.

In addition to recessing the material 434 in the openings and providing a spacer material, in some examples, a sacrificial material can be provided at the bottom of the narrower opening. FIG. 4G illustrates an example IC structure 400G resulting from the process of providing a sacrificial material 409 at the bottom of the narrower opening 454-2. In one example, the opening 454-2 is further opened (e.g., the bottom of the opening 454-2 is etched to make the opening 454-2 deeper with any suitable etching technique). The sacrificial material 409 can then be provided at the bottom of the opening 454-2. Prior to providing the sacrificial material, the method 300 may first involve providing a mask over the first side 445 of the IC structure 400G with an opening over the narrower S/D opening 454-2 and covering the wider S/D opening 454-1. In one such example, the sacrificial material 409 may then be provided in accordance with any suitable deposition technique. In one example, the sacrificial material 409 includes or is titanium nitride or another suitable sacrificial material that can later be removed from the backside without excessively damaging the S/D material that is provided in the opening 454-2 over the sacrificial material 409 in a later process.

Referring again to FIG. 3, the method 300 continues with the process 306 of providing a semiconductor material in the first and second openings. FIG. 4H illustrates an example IC structure 400H resulting from the process 306. As can be seen in FIG. 4H, remaining portions of the openings 454 may be filled with respective S/D materials, shown as an S/D material 470 in the openings 454. The S/D materials 470 may include any materials for forming S/D regions (e.g., such as the S/D regions 114 of FIG. 1) of nanoribbon-based transistors. In one example, the S/D material includes a doped semiconductor material. Techniques for filling S/D openings with an S/D material during fabrication of nanoribbon-based transistors are known in the art and, therefore, are not described here in detail. Thus, the IC structure 400H includes S/D regions 459-1, 459-2, where one of the regions 459-1, 459-2 is a source region and the other of the regions 459-1, 459-2 is a drain region. In the example illustrated in FIG. 4H, the width of the S/D material 470 in the openings 454-2 and 454-1, and thus the width of the S/D regions 454-1 and 454-2 is different. For example, the S/D region 459-1 has a first width 410-1 and the S/D region 459-1 has a second width 410-2, where the first width is greater than the second width (i.e., the second width is smaller than the first width).

In one example, after forming the S/D regions, the method can then involve the process of removing the dummy gate material, releasing the nanoribbons, and providing a gate electrode material. FIG. 4I illustrates an example IC structure 4001 resulting from the process of removing the dummy gate and releasing the nanoribbons. Removal of the dummy gate 446 may include any suitable etching technique, provided the material of the dummy gate 446 is sufficiently etch-selective with respect to the other materials of the IC structure 4001, in particular, with respect to the semiconductor material 432 and the insulator material 436 surrounding the subfin portion of the fin 440. Removing the dummy gate exposes the material 434 and the semiconductor material 432 at the sidewalls of the fin 440. An etch process may then be used to remove the material 434 from the fin 440, starting from the portions of the material 434 that are exposed by the removal of the dummy gate 446. As a result of removing the material 434, a stack 478 of nanoribbons of the semiconductor material 432 is formed from the fin 440. Thus, the nanoribbons of the stack 478 are "released" in that the openings 473 are formed around channel portions of the nanoribbons of the semiconductor material 432.

FIG. 4J illustrates an example IC structure 400J resulting from the process of providing a gate electrode material 484 around portions of the nanoribbons of the stack 478. The gate electrode material 484 may be the same as, or similar to, the gate electrode material 108 described above with respect to FIG. 1. FIG. 4J further illustrates a gate insulator material 482 that may wrap around the gate regions of the nanoribbons of the stack 478. The gate insulator material 482 may be the same as or similar to the gate insulator material 112 described above with respect to FIG. 1. In the example illustrated in FIG. 4J, a layer of the gate insulator material 482 is also formed over the insulator material 436 and the semiconductor material 432 of the subfin under the stacks 478. In some embodiments, the gate insulator material 482 may be absent in the IC structure 400J.

Referring again to FIG. 3, the method 300 continues with the process 307 of providing a first contact structure over the semiconductor material in the first opening from the first side of the IC structure. FIG. 4K illustrates an example IC structure 400K resulting from the process 307. As can be seen in FIG. 4K, an S/D contact 494-1 is provided over the S/D material 470 of the S/D region 459-1 from the first side 445 of the IC structure 400K. The S/D contact structure 494-1 includes an S/D contact material 480 that fills the remainder of the openings 454-1 and makes an electrical contact with the S/D material 470. The S/D contact material 480 may include, e.g., tungsten and/or another electrically conductive material. In the example illustrated in FIG. 4K, the IC structure 400K further includes an interface material 461 to provide an interface between the S/D material 470 of the S/D region 459-1 and the electrically conductive fill material 480 of the S/D contact 494-1. The interface material 461 may include/be a metal such as titanium which, once deposited, may intermix with the material of the S/D regions 459, e.g., with silicon, forming a compound (e.g., titanium silicide) that may help reduce contact resistance of the S/D contact 494-1. In the example illustrated in FIG. 4K, the second S/D contact structure for the second S/D region 459-2 is to be provided from the second side of the IC structure 400K. Therefore, in one example, the opening 452-1 at the first side of the IC structure 400K is filled with an insulator material 411. The insulator material may include, for example, a nitride or other suitable insulator material. In some examples, the insulator material 411 may be the same as an insulator material provided over the gate electrode material 484 to prevent source/drain contacts to gate shorts.

Referring to FIG. 3, the method 300 continues with the process 308 of flipping over the IC structure to expose a second side of the IC structure. FIG. 4L illustrates an example IC structure 400L resulting from the process 307. As can be seen in FIG. 4L, the IC structure 400L is flipped over to enable processing from the second side 447 of the IC structure 400L.

The method 300 may then involve forming an opening for a contact structure from the second side 447 of the IC structure 400L. FIG. 4M illustrates an example IC structure 400M resulting from forming an opening 413 over the S/D contact 459-2 from the second side 447. As can be seen in FIG. 4M, the opening 413 exposes the S/D material 470 at a bottom of the S/D region 459-2 from the second side 447. In one example, prior to forming the opening 413, one or more layers (such as the support 401) may be removed from the second side 447. In one example, the semiconductor material 432 (e.g., the layer of semiconductor material 432 that was under the stack 478 of nanoribbons as shown in FIG. 4K) may be removed and replaced with an insulator material 415. The insulator material 415 may be, for example, silicon oxide or another suitable insulator material. In other examples, the semiconductor material 432 may not be replaced by an insulator material.

Referring again to FIG. 4M, in one example, forming the opening 413 involves removing the sacrificial material 409 over the S/D region 459-2 (note that the sacrificial material 409 is depicted as over the S/D region 459-2 in FIG. 4L after flipping over the IC structure). Removing the sacrificial material may involve, for example, any suitable etching technique such as the techniques mentioned above with respect to FIG. 4B. In one example, an etching process that is sufficiently etch-selective with respect to the surrounding materials (e.g., the insulator material 415) is used, and the sacrificial material 409 may be removed without masking. In an example in which one or more other materials are disposed over the sacrificial material 409 (e.g., such as the support 401 in an example in which the support is not removed, or the insulator material 415), forming the opening 413 may involve etching one or more other materials over the sacrificial material 409 prior to removing the sacrificial material 409.

As can be seen in FIG. 4M, after removing the sacrificial material 409, the S/D material 470 is exposed through the opening 413. In one example, the width of the opening 413 may be relatively narrow (e.g., about the width 410-2 of the S/D region 459-2). Therefore, in some examples, the method may involve widening the opening 413. FIG. 4N illustrates an example IC structure 400N resulting from widening the opening 413. Widening the opening 413 may involve any suitable etching technique, such as the techniques described above. For example, widening the opening 413 may involve wet etching or dry etching sidewalls of the opening 413 exposed by removing the sacrificial material 409. In one example, a wet etch process that is selective to the S/D material 470 is used to etch the insulator material 415 on the sidewalls of the opening 413. Widening the opening 413 can enable subsequent formation of a wider contact structure for the S/D region 459-2 (such as illustrated in FIG. 2B). In other examples, the opening 413 may not necessarily be widened, which may result in subsequent formation of a contact structure having a width that is narrower (e.g., about the same as the width of the S/D region 459-2, such as illustrated in FIG. 2A).

After forming the opening 413 for the contact structure and optionally widening the opening 413, the method 300 involves a process 309 of providing a second contact structure over the semiconductor material in the second opening from the second side. FIG. 4O illustrates an example IC structure 4000 resulting from the process 309. As can be seen in FIG. 4O, the IC structure 4000 includes a second contact structure 494-2 at a second side 447 of the IC structure 400O, where the second side 447 is opposite the first side 445 from which the first contact structure 494-1 was formed. The contact structure 494-2 includes an electrically conductive material 480. Although the contact structures 494-1, 494-2 are shown as including the same electrically conductive material 480, the contact structures 494-1, 494-2 do not necessarily have the same material composition. Like the contact structure 494-1 on the first side, the contact structure 494-2 shown in FIG. 4O includes an interface material 461 between the electrically conductive material 480 and the S/D material 470, although in other examples, the interface material 461 may be absent.

In some examples, the method 300 may involve providing another semiconductor over the S/D region prior to providing the interface material 461 and conductive material 480, such as shown in FIG. 2C. In one such example where the S/D region includes a first semiconductor material 470, a second semiconductor material may be provided over the first semiconductor material 470 (e.g., to fill in a gap that may have resulted from defects and/or from forming the opening 413). In one such example, the second semiconductor material may be formed with a relatively low temperature epitaxial deposition process. In other examples, a second semiconductor material between the first semiconductor material of the S/D region 459-2 and the contact structure 494-2 is absent.

The widths of a S/D contact structures may depend on the widths of a corresponding S/D regions. Forming a contact structure that is significantly larger than the corresponding S/D region to which the contact structure is coupled may not result in a larger contact area, and therefore may not have significant benefits, while potentially risking inadvertent conduction between the contact structure and adjacent elements. Conversely, forming a contact structure that is significantly smaller than a corresponding S/D region can result in poor conduction. In the example illustrated in FIG. 4O, the contact structure 494-2 has a width 419-2 that is greater than the width 410-2 of the S/D region 459-2. In one such example, the width 419-2 of the contact structure 494-2 is 5-60% larger than the width 410-2 of the corresponding S/D region 459-2. In other examples, the width 419-2 of the contact structure 494-2 is 20-40% or 25-35% larger than the width 410-2 of the corresponding S/D region 459-2. In one such example, the difference in width between the S/D regions 459-1, 459-2 is in a range of about 2-5 nanometers. In other examples, the width 419-2 of the contact structure 494-2 is not larger than the width 410-2 of the corresponding S/D structure 459-2 (e.g., the width 419-2 of the contact structure 494-2 is about the same as or smaller than the width 410-2 of the corresponding contact structure 494-2). In an example in which the width 419-2 of the contact structure 494-2 is larger than the width 410-2 of the corresponding S/D region 459-2, the width 419-2 has a value between the width 410-2 of the S/D region 459-2 and the width 419-1 of the contact structure 494-1. In various embodiments, the width 419-2 of the second contact structure 494-2 may be about the same as, larger than, or smaller than the width 419-1 of the first contact structure 494-1.

In the example illustrated in FIG. 4O, the IC structure 400O lacks a liner on sidewalls of the opening 413 for the contact structure 494-2 (e.g., a liner is absent between the conductive material 480 of the contact structure 494-2 and the material surrounding the contact structure, such as the insulator material 415). In one example, the IC structure 400O includes a liner 456 of a liner material on sidewalls of the first contact structure 494-1, and the second contact structure 494-2 lacks a liner of the same liner material on sidewalls of the second contact structure 494-2 (although there may be a liner including a different liner material on sidewalls of the second contact structure 494-2). In other examples, one or more liners may be present between the conductive material 480 of the contact structure 494-2 and the insulator material 415, including a liner having the same liner material as the liner 456.

The IC structure 400O also includes an interconnect layer 417 over the insulator material 415. One or more interconnect layers may be formed above and below a device region 420 of the IC structure 400O. For example, FIG. 4P illustrates an IC structure that has been flipped to enable one or more interconnect layers to be provided from a front side 445 of the IC structure 400P. As can be seen in FIG. 4P, the IC structure 400P includes an interconnect layer 422 over the device region 420 of the IC structure 400P. Although a single interconnect layer 422 is shown over the first side 445 and a single interconnect layer 417 is shown under the second side 447 of the IC structure 400P, one or more additional interconnect layers may be present above the interconnect layer 422 or below the interconnect layer 417.

A collection of interconnect layers (e.g., the interconnect layer 422 and one or more other interconnect layers above the layer 422, which is not depicted in FIG. 4P) may be referred to as a "metallization stack" of the IC structure 400P. Interchangeably, a metallization stack may be referred to as the "back end of line (BEOL) layer(s)" of the IC device 400P, while the device region 420 may be referred to as the "front end of line (FEOL) layer(s)" of the IC device 400P. Electrical signals, such as power and/or input/output (I/O) signals, may be routed to and/or from the devices (e.g., the transistors) of the device region 420 through one or more interconnect layers disposed on the device region 420 (e.g., illustrated in FIG. 4P as interconnect layer 422). For example, electrically conductive features of the device region 420 (e.g., the electrically conductive material 484 of a gate contact structure 423 and the electrically conductive material 480 of S/D contact structure 494-1) may be electrically coupled with an interconnect structure of the interconnect layer 422. For example, in FIG. 4P, the S/D contact 494-1 is coupled with the interconnect structure 421. Interconnect structures 428 may be arranged within the interconnect layers of the metallization stack to route electrical signals according to a wide variety of designs. The interconnect layers 417, 422 may include a dielectric material disposed between the interconnect structures 428, 418. In some embodiments, the dielectric material disposed between the interconnect structures 428, 418 in different ones of the interconnect layers 417, 422 may have different compositions; in other embodiments, the composition of the dielectric material of different interconnect layers 417, 422 may be the same.

The IC structure 400P and all variations of such structures described herein are examples of the IC structures 100 and 200A-200C, described above. Performing the method 300 may result in features in the final IC structures that are characteristic of the use of the method 300. For example, one such feature is illustrated in the IC structure 400P shown in FIG. 4P, which shows an IC structure including a first region 459-1 and a second region 459-2, where one of the first region and the second region is a source region of a transistor, and another of the first region and the second region is a drain region of the transistor, and where the first region 459-1 has a first width 410-1 that is greater than a second width 410-2 of the second region 459-2. Thus, the IC structure 400P includes asymmetric source/drain regions. In some examples, the corresponding contact structures may also be asymmetric. For example, the contact structure 494-2 coupled with the narrower S/D region 459-2 may have a narrower width than the contact structure 494-1 coupled with the wider S/D region 459-1. In one example, the narrower S/D region 459-2 is a source region and/or is coupled with an S/D contact from a second side 447 (e.g., back side) of the IC structure, where the second side 447 is a side that is opposite a first side 445 from which the S/D region 459-1 was formed.

Providing asymmetric S/D regions can enable increasing the width of one of the S/D regions and/or increasing the channel length without increasing the transistor size. For example, consider an IC structure (e.g., the IC structure 400P) in which one of the S/D regions of a transistor has a narrower width than the other S/D region of the transistor. By reducing the width of one of the S/D regions (e.g., the S/D region 459-2), the width of other features can be increased, such as the channel length 425 and/or the width of the other S/D region (e.g., the S/D region 459-1), where the channel length 425 is a dimension of a channel region of a nanoribbon in a plane parallel with a support over which the IC structure is disposed (e.g., along the y-axis as shown in FIG. 4P). In one example, a transistor having asymmetric source/drain regions in which the drain side has a larger width can have performance benefits (e.g., due to the drain side design having more complexity and/or due to the relative ease of current control through source contact compared to the drain contact). Furthermore, a transistor having asymmetric source/drain regions in which the narrower S/D region is coupled with a contact from a second side can enable widening of the S/D contact coupled with the narrower S/D region due to more flexibility in processing on the second side (e.g., due to the proximity of adjacent features to S/D contacts on the second side compared to the first side).

IC structures including asymmetric S/D contacts as described herein (e.g., as described with reference to FIGS. 1-4) may be used to implement any suitable components. For example, in various embodiments, transistors described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC structures disclosed herein, e.g., the IC structures 100, 200A-200C, and 400P may be included in any suitable electronic component. FIGS. 5-9 illustrate various examples of apparatuses that may include any of the IC structures 100, 200A-200C, and 400P disclosed herein.

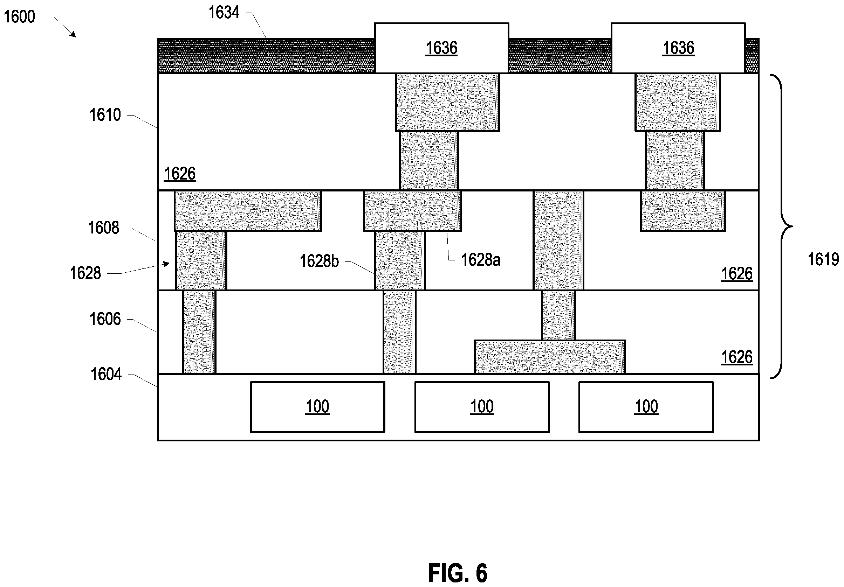

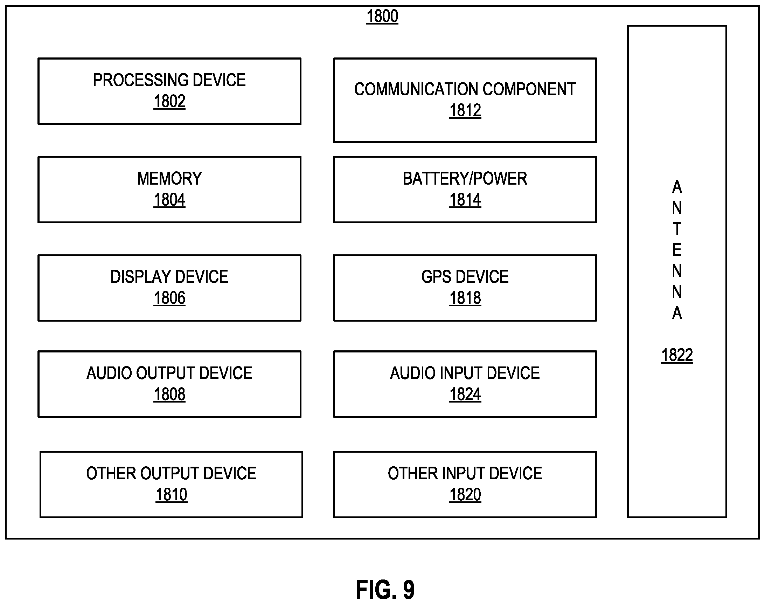

FIG. 5 is a top view of a wafer 1500 and dies 1502 that may include one or more IC structures 100, 200A-200C, and 400P in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures 100, 200A-200C, and 400P (e.g., as discussed below with reference to FIG. 6), one or more transistors (e.g., some of the transistors of the device region 1604 of FIG. 6, discussed below, e.g., nanoribbon-based transistors of the IC structures 100, 200A-200C, and 400P) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 9) or other logic that is configured to store information in the memory devices or execute instructions stored in the memory array.

FIG. 6 is a side, cross-sectional view of an IC device 1600 that may include one or more IC structures in accordance with any of the embodiments disclosed herein (e.g., in accordance with IC structures 100, 200A-200C, and 400P). One or more of the IC devices 1600 may be included in one or more dies 1502 (FIG. 5). The IC device 1600 may include a device region 1604 including one or more IC structures (e.g., one or more of IC structures 100, 200A-200C, and 400P) disclosed herein, or any variations of the IC structures. The device region 1604 may further include electrical contacts to the gates of the transistors included in the device region 1604 and to the S/D materials of the transistors included in the device region 1604 (e.g., to the S/D regions 114 of the IC structure 100).

Electrical signals, such as power and/or input/output (I/O) signals, may be routed to and/or from the devices (e.g., the transistors) of the device region 1604 through one or more interconnect layers disposed on the device region 1604 (illustrated in FIG. 6 as interconnect layers 1606-1610). For example, electrically conductive features of the device region 1604 (e.g., the gate electrode material 108 of the IC structure 100) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 6). Although a particular number of interconnect layers 1606-1610 is depicted in FIG. 6, embodiments of the present disclosure include IC structures having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the support 102 upon which the device region 1604 is formed. For example, the lines 1628a may route electrical signals in a direction in and out of the page from the perspective of FIG. 6. The vias 1628b may be arranged to route electrical signals in a direction of a plane that is substantially perpendicular to the surface of the support 102 upon which the device region 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 6. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device region 1604. In some embodiments, the first interconnect layer 1606 may include lines 1628a and/or vias 1628b, as shown. The lines 1628a of the first interconnect layer 1606 may be coupled with contacts (e.g., contacts to the S/D regions 114 of the IC structure 100) of the device region 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device region 1604) may be thicker.

The IC device 1600 may include a solder resist material 1634 (e.g., polyimide or similar material) and one or more conductive contacts 1636 formed on the interconnect layers 1606-1610. In FIG. 6, the conductive contacts 1636 are illustrated as taking the form of bond pads. The conductive contacts 1636 may be electrically coupled with the interconnect structures 1628 and configured to route the electrical signals of the transistor(s) of the device region 1604 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

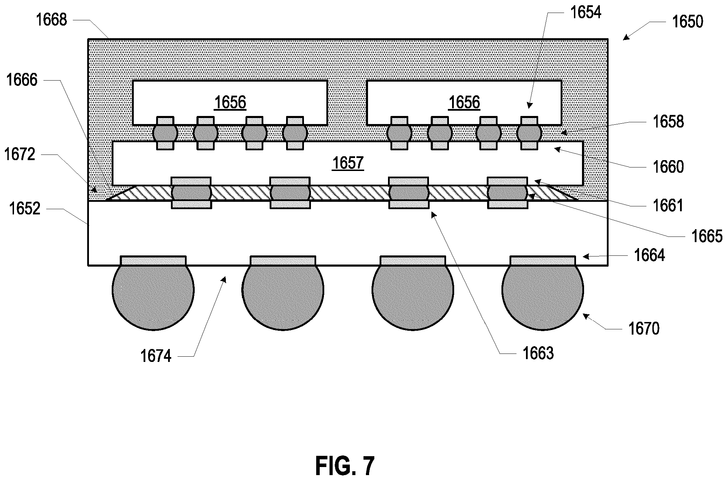

FIG. 7 is a side, cross-sectional view of an example IC package 1650 that may include one or more IC structures 100, 200A-200C, and 400P in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnects 1628 discussed above with reference to FIG. 6.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 7 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 7 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 7 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 6.

The dies 1656 may take the form of any of the embodiments of the die 1502 discussed herein (e.g., may include any of the embodiments of the IC device 1600). In embodiments in which the IC package 1650 includes multiple dies 1656, the IC package 1650 may be referred to as a multichip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 7 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 7, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

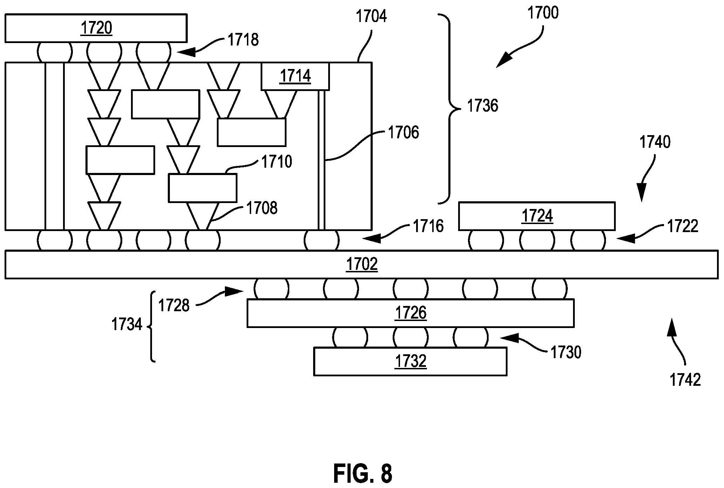

FIG. 8 is a side, cross-sectional view of an IC device assembly 1700 that may include one or more IC packages or other electronic components (e.g., a die) including one or more IC structures 100, 200A-200C, and 400P in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 7 (e.g., may include one or more IC structures 100, 200A-200C, and 400P).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 8 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 8), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 8, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 5), an IC device (e.g., the IC device 1600 of FIG. 6), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 8, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 8 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 9 is a block diagram of an example electrical device 1800 that may include one or more IC structures 100, 200A-200C, and 400P in accordance with any of the embodiments disclosed herein. For example, any suitable ones of the components of the electrical device 1800 may include one or more of the IC device assemblies 1700, IC packages 1650, IC devices 1600, or dies 1502 disclosed herein. A number of components are illustrated in FIG. 9 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 9, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure including a first region and a second region of a transistor, where one of the first region and the second region is a source region of the transistor, and another of the first region and the second region is a drain region of the transistor. The IC structure includes a first contact structure (e.g., drain contact structure) coupled to the first region (e.g., drain region) from a first side (e.g., front side) of the IC structure, and a second contact structure (e.g., source contact structure) coupled to the second region (e.g., source region) from a second side (e.g., back side) of the IC structure, where the first region has a first width (e.g., width of the drain region) and the second region has a second width (e.g., width of the source region) that is smaller than the first width.

Example 2 provides an IC structure in accordance with example 1, where the second region is the source region of the transistor.

Example 3 provides an IC structure in accordance with examples 1 or 2, where the second contact structure has a third width that is larger than the second width.

Example 4 provides an IC structure in accordance with any one of examples 1-3, where the second contact structure has a third width, and the first contact structure has a fourth width that is larger than the third width.

Example 5 provides an IC structure in accordance with any one of examples 1-4 where the second contact structure includes a conductive material, the second region includes a first semiconductor material, and the IC structure further includes a second semiconductor material (e.g., grown with a low temperature epitaxial deposition technique) between the conductive material and the first semiconductor material.

Example 6 provides an IC structure in accordance with example 5, further including an interface material between the second semiconductor material and the conductive material.

Example 7 provides an IC structure in accordance with examples 5 or 6, where the second semiconductor material has at least one different material property than the first semiconductor material, including one or more of: a different material composition and a different crystal direction.

Example 8 provides an IC structure in accordance with any one of examples 1-7 where the first contact structure includes a liner of a liner material on sidewalls of the first contact structure, and the second contact structure lacks a liner of the liner material on sidewalls of the second contact structure.

Example 9 provides an IC structure in accordance with any one of examples 1-8, where the second width is 5-60% smaller than the first width.

Example 10 provides an IC structure including a transistor over a support, the transistor including a channel region, a source region, and a drain region, a source contact structure coupled with the source region, and a drain contact structure coupled with the drain region, where the drain region has a first width in a plane substantially parallel to the support, the source region has a second width in the plane, and wherein the first width is different than the second width.

Example 11 provides an IC structure in accordance with example 10, where the source contact structure has a third width that is larger than the second width.

Example 12 provides an IC structure of claims 10 or 11, where the source contact structure has a third width, and the drain contact structure has a fourth width that is smaller than the third width.

Example 13 provides an IC structure in accordance with any one of examples 10-12, where the source contact structure includes a conductive material, the source region includes a first semiconductor material, and the IC structure includes a second semiconductor material between the conductive material and the first semiconductor material, wherein the second semiconductor material is in contact with the first semiconductor material.

Example 14 provides an IC structure in accordance with examples 13, further including an interface material between the second semiconductor material and the conductive material, where the interface material is in contact with the second semiconductor material.

Example 15 provides an IC structure in accordance with examples 13 or 14, where the second semiconductor material has at least one different material property than the first semiconductor material.

Example 16 provides an IC structure in accordance with any one of examples 10-15, further including a liner on sidewalls of the drain contact structure, where a liner is absent from sidewalls of the source contact structure.

Example 17 provides an IC structure of any one of examples 1-16, where the second width is 25-35% smaller than the first width.

Example 18 provides an IC structure according to any one of examples 1-17, where the IC structure includes or is a part of a central processing unit.

Example 19 provides an IC structure according to any one of examples 1-18, where the IC structure includes or is a part of a memory device.

Example 20 provides an IC structure according to any one of examples 1-19, where the IC structure includes or is a part of a logic circuit.

Example 21 provides an IC structure or IC device according to any one of examples 1-20, where the IC structure or IC device includes or is a part of input/output circuitry.

Example 22 provides an IC structure or IC device according to any one of examples 1-21, where the IC structure or IC device includes or is a part of a field programmable gate array transceiver.

Example 23 provides an IC structure or IC device according to any one of examples 1-22, where the IC structure or IC device includes or is a part of a field programmable gate array logic.

Example 24 provides an IC structure or IC device according to any one of examples 1-23, where the IC structure or IC device includes or is a part of a power delivery circuitry.

Example 25 provides an IC package that includes an IC die including an IC structure or IC device according to any one of examples 1-24; and a further IC component, coupled to the IC die.

Example 26 provides an IC package according to example 25 where the further IC component includes a package substrate.

Example 27 provides an IC package according to example 25, where the further IC component includes an interposer.

Example 28 provides an IC package according to example 25, where the further IC component includes a further IC die.

Example 29 provides a computing device that includes a carrier substrate and an IC structure or IC device coupled to the carrier substrate, where the IC structure or device is an IC structure or device according to any one of examples 1-24, or the IC structure or device is included in the IC package according to any one of examples 25-28.

Example 30 provides a computing device according to example 29, where the computing device is a wearable or handheld computing device.

Example 31 provides a computing device according to examples 29 or 30, where the computing device further includes one or more communication chips.

Example 32 provides a computing device according to any one of examples 29-31, where the computing device further includes an antenna.

Example 33 provides a computing device according to any one of examples 29-32, where the carrier substrate is a motherboard.

Example 34 provides a method of fabricating an IC structure, the method including providing a stack of nanoribbons over a support, forming a first opening in the stack of nanoribbons, wherein the first opening has a first width in a plane substantially parallel to the support, forming a second opening in the stack of nanoribbons, wherein the second opening has a second width in the plane, and wherein the second width is smaller than the first width, providing a semiconductor material in the first opening and the second opening, providing a first contact structure to couple with the semiconductor material in the first opening, and providing a second contact structure to couple with the semiconductor material in the second opening, wherein one of the first contact structure and the second contact structure is a source contact structure, and another of the first contract structure and the second contact structure is a drain contact structure.

Example 35 provides a method according to example 34, where the first opening and the second opening are formed at a first side of the IC structure, and providing the second contact structure includes flipping over the IC structure to expose a second side of the IC structure, forming a third opening from the second side to expose the semiconductor material in the second opening, and filling the third opening with a conductive material.

Example 36 provides a method according to examples 34 or 35, wherein prior to filling the third opening with a conductive material, the method includes widening the third opening.

Example 37 provides a method according to any one of examples 34-36, where the IC structure is an IC structure according to any one of the preceding examples.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a first region (259-1) and a second region (259-2) of a transistor, wherein one of the first region and the second region is a source region of the transistor, and another of the first region and the second region is a drain region of the transistor;
a first contact structure (294-1) coupled to the first region from a first side of the IC structure; and
a second contact structure (294-2) coupled to the second region from a second side of the IC structure;
wherein the first region has a first width and the second region has a second width that is smaller than the first width.

2. The IC structure of claim 1, wherein:
the second region is the source region of the transistor.

3. The IC structure of claims 1 or 2, wherein:
the second contact structure has a third width that is larger than the second width.

4. The IC structure of any one of claims 1-3, wherein:
the second contact structure has a third width; and
the first contact structure has a fourth width that is larger than the third width.

5. The IC structure of any one of claims 1-4, wherein:
the second contact structure includes a conductive material (280);
the second region includes a first semiconductor material (270); and
the IC structure further includes a second semiconductor material (227) between the conductive material and the first semiconductor material.

6. The IC structure of claim 5, further comprising:
an interface material (261) between the second semiconductor material and the conductive material.

7. The IC structure of claim 6, wherein:
the second semiconductor material is in contact with the interface material and the first semiconductor material.

8. The IC structure of any one of claims 5-7, wherein:
the second semiconductor material has at least one different material property than the first semiconductor material, including one or more of: a different material composition and a different crystal direction.

9. The IC structure of any one of claims 1-8, wherein:
the first contact structure includes a liner of a liner material on first sidewalls of the first contact structure; and
the second contact structure lacks a liner of the liner material on second sidewalls of the second contact structure.

10. The IC structure of any one of claims 1-9, wherein:
the second width is 5-60% smaller than the first width.

11. The IC structure of any one of claims 1-9, wherein:
the second width is 25-35% smaller than the first width.

12. A method of fabricating an integrated circuit (IC) structure, the method comprising:
providing a stack of nanoribbons over a support;
forming a first opening in the stack of nanoribbons, wherein the first opening has a first width in a plane substantially parallel to the support;
forming a second opening in the stack of nanoribbons, wherein the second opening has a second width in the plane, and wherein the second width is smaller than the first width;
providing a semiconductor material in the first opening and the second opening;
providing a first contact structure to couple with the semiconductor material in the first opening; and
providing a second contact structure to couple with the semiconductor material in the second opening, wherein one of the first contact structure and the second contact structure is a source contact structure, and another of the first contact structure and the second contact structure is a drain contact structure.

13. The method of claim 12, wherein:
the first opening and the second opening are formed at a first side of the IC structure; and
providing the second contact structure includes:
flipping over the IC structure to expose a second side of the IC structure,
forming a third opening from the second side to expose the semiconductor material in the second opening, and
filling the third opening with a conductive material.

14. The method of claim 13, wherein:
prior to filling the third opening with the conductive material, the method includes widening the third opening.

15. The method of claim 13, wherein:
prior to filling the third opening with a conductive material, the method includes forming a layer of a second semiconductor material over the semiconductor material in the second opening.
